# EUROPEAN PATENT APPLICATION

(11) **EP 4 712 728 A2**
(43) Date of publication of application: **18.03.2026**
(21) Application number: 25202909.5
(22) Date of filing: 17.09.2025
(51) Int. Cl.: H10D 64/23, H10D 64/27, H10D 84/05, H10D 84/82, H10D 30/47, H10D 62/10, H10D 62/85

(54) **A LATERAL ORIENTED TRANSISTOR EMBODIED IN A SEMICONDUCTOR MATERIAL AND A CORRESPONDING SEMICONDUCTOR PACKAGE**

(30) Priority: 17.09.2024 NL 2038646
(71) Applicant: Nexperia B.V., 6534 AB Nijmegen (NL)
(72) Inventor: Sherman, Daniel, Manchester (GB); Martin Horcajo, Sara, Manchester (GB); Parkin, Jim, Manchester (GB); Robson, Malcolm, Manchester (GB); Brown, Adam, Manchester (GB)

(57) **Abstract**

A lateral oriented transistor embodied in a semiconductor material, comprising a first group of directly adjacently placed transistor cells, a second group of directly adjacently placed transistor cells, wherein said second group is spaced apart from said first group thereby providing a spacing, wherein each of said transistor cells comprises a drain, a source and a gate, wherein said lateral oriented transistor further comprises a gate interconnect placed in said spacing between said first and second group, wherein said gate interconnect connects to said gates of said transistor cells

## Description

### Technical Field

The present disclosure relates to a semiconductor device comprising a lateral oriented transistor embodied in a semiconductor material and corresponding semiconductor package.

### Background

As semiconductor devices, especially power transistors such as MOSFETs and GaN transistors, continue to scale up in size and power capacity, the electrical interconnections within these devices play a role in their overall performance and reliability. This involves the use of metal layers to form electrical connections between various terminals, such as gate, source, and drain, and other components within the device. However, as device sizes increase, the associated metal interconnects face increased resistance (R) and capacitance (C). This combination results in RC delays, which can impact the switching behavior of the device.

RC delay relates to the time it takes for a signal to propagate through the metal interconnects due to the resistance of the metal paths and the parasitic capacitance formed between the metal layers and surrounding materials. As the device size grows, the resistance increases due to the longer metal traces, while capacitance rises due to the larger surface areas involved. These delays may cause a spread in the timing of signals across the device, leading to inhomogeneous turn-on and turn-off behaviors. This uneven switching may result in non-uniform current distribution and localized hotspots, which are areas of excessive heating. Such inhomogeneities may stress the device, potentially leading to reliability issues over time, such as accelerated wear, thermal degradation, and even device failure.

These effects may be important for GaN devices, which are designed for high-speed switching rates. GaN transistors are valued for their high electron mobility, enabling them to switch at much faster rates compared to traditional silicon-based devices. However, their sensitivity to RC delays may also be heightened due to these fast-switching speeds.

### Summary

Therefore, it would be advantageous to achieve a transistor which is able to homogenise the response of different transistor cells that constitute the transistor.

In a first aspect of the disclosure, there is provided a lateral oriented transistor embodied in a semiconductor material, comprising:
- a first group of directly adjacently placed transistor cells;
- a second group of directly adjacently placed transistor cells, wherein said second group is spaced apart from said first group thereby providing a spacing;
   wherein each of said transistor cells comprises a drain, a source and a gate;
wherein said lateral oriented transistor further comprises a gate interconnect placed in said spacing between said first and second group, wherein said gate interconnect connects to said gates of said transistor cells.

The inventors have found that it may be beneficial to provide a lateral oriented transistor comprising a plurality of parallel groups of transistor cells, wherein the gates of these groups are connected with a gate interconnect. This gate interconnect is placed in a spacing that separates the groups of transistor cells. This is done to ensure a more homogenous response of the multiple cells, by reducing the RC delay along the gate, so the cells switching times are more similar.

The transistor cells are all connected in parallel which reduces the overall resistance of the transistor.

In other words, a gate bus bar may be provided in a spacing separating the first group of transistor cells with the second group of transistor cells.

In an example of the disclosure, the lateral oriented transistor is a Gallium Nitride, GaN, High Electron Mobility Transistor, HEMT.

The inventors have found that due to the fast switching speeds of GaN HEMTs, it would be beneficial to have homogeneous turn-on and turn-off times of the respective transistor cells. This is accomplished by the transistor of the present disclosure.

A GaN HEMT (Gallium Nitride High Electron Mobility Transistor) is a type of transistor that uses gallium nitride (GaN) and aluminum gallium nitride (AlGaN) materials to create a high-speed, high-efficiency device. The HEMT structure forms a two-dimensional electron gas (2DEG) at the interface between the GaN and AlGaN layers, allowing electrons to move with minimal resistance. GaN HEMTs are known for their ability to handle high voltages, high power, and operate at high frequencies, making them ideal for applications like RF amplifiers, power electronics, and radar systems.

In an example of the disclosure, wherein, seen from a top view of said laterally oriented transistor:
- one of the corresponding source and the drain wraps around gate; and
- the gate wraps around the corresponding other of the source and the drain.

The advantage of the gate and source wrapping around the first source/drain contact is that it provides a good isolation between the source and drain. This improves the performance of the transistor device by mitigating leakage between the source and the drain, which can reduce a sub-threshold hump in the drain current versus gate voltage relation of the transistor device.

The gate in the described transistor design may thus wrap around the source/drain contact in a continuous, closed loop. This may prevent current leakage around the corresponding source/drain contact. The second source/drain contact, in turn, wraps around the gate, forming another continuous loop. This may improve the transistor's performance by minimizing leakage currents, which enhances overall device efficiency and electrical isolation.

In an example of the disclosure, the transistor cells of a same group are directly adjacent such that they share a part of said one of said source and drain.

As will be clarified in the figure description, the drains or sources share a part of their loop. For example, a sidewall of the source can be shared between adjacently placed transistor cells. In this way, a continuous structure is created. This allows for a more condensed transistor cell.

In an example of the disclosure, said transistor comprises a source metallization plane and a drain metallization plane, wherein drains of said transistor cells are connected to said drain metallization plane using drain vias and sources of said transistor cells are connected to said source metallization plane using source vias.

In an example of the disclosure said source metallization plane and said drain metallization plane are oriented on a same layer.

In an example of the disclosure, the source metallization plane and the drain metallization plane are separated diagonally relative to a longitudinal direction of said spacing such that at least one triangular source metallization plane and at least one triangular drain metallization plane are formed.

A triangular metal metallization plane configuration as described in the example leads to lower series resistance between source and drain. This reduces the voltage drop across the metallization layer under high current density and high switching speeds, which result in a more uniform cell operation across the device. This metallization design allows for balancing current density across the device, therefore preventing current crowding, and further contributes to the device reliability and to a more homogeneous behaviour of the dynamics across the device.

In an example of the disclosure, said drains of said transistor cells are connected to said drain metallization plane using drain vias directly underneath said drain metallization plane, and wherein sources of said transistor cells are connected to said source metallization plane using source vias directly underneath said source metallization plane.

In an example of the disclosure, said diagonal separation is formed within a same group of transistor cells.

The triangular drain and source metallization planes are formed within the same group of transistor cells. This allows for even distribution of the source versus drain plane and their relative connection to the source and drain. This allows for the desired effect of a homogenous current distribution within the transistor cells and the semiconductor package as a whole. The triangular drain and source metallization planes, i.e. busbars, each crosses over multiple drain and source regions of the same group of transistor cells. However, the source and drain busbars only are connected to their respective drain and source region of the same group of transistor cells with a via.

In an example of the disclosure, the gate interconnect is positioned in a metallization layer.

In an example of the disclosure, said gate interconnect is positioned in a same metallization layer as said drain metallization plane and said source metallization plane.

In an example of the disclosure, the gate interconnect extends longitudinally between said two groups of transistor cells.

To provide the gate interconnect in this way and to ensure sufficient insulation between the source and gate, a spacing between the source and the gate is required. This results in a spacing, which may not be uniform along the longitudinal direction.

In an example of the disclosure, said transistor further comprises:
- a further gate interconnect, parallel to said gate interconnect, and place at an opposite side of at one of said first and second group of transistor cells.

In order to provide the homogenous current distribution, it may be beneficial to provide for an additional gate interconnect. It may further allow additional transistor cells to be connected to this additional gate interconnect. Therefore, a device comprising a plurality of transistor cells may be provided. Each transistor cell with a homogeneous current distribution.

In an example of the disclosure, each of said first and second group of transistor cells comprises between twenty to eighty transistor cells.

Preferably each of said first and second group of transistor cells comprises 20 to 80 transistor cells. This may depend on the pitch of the cells which may be determined by the drain-source separation.

The triangular source and drain planes are spread out over the at least three transistor cells. This means that only one source plane and one drain plane is formed over these three transistor cells.

In a second aspect of the disclosure, there is provided a semiconductor package comprises a lateral oriented transistor in accordance with the disclosure.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

The above and other aspects of the disclosure will be apparent from and elucidated with reference to the examples described hereinafter.

### Brief description of the figures

Fig. 1 depicts a transistor cell in accordance with the disclosure;
Fig. 2 depicts a lateral oriented transistor embodied in a semiconductor material in accordance with the disclosure;
Fig. 3 depicts a lateral oriented transistor embodied in a semiconductor material in accordance with the disclosure;
Fig. 4 depicts a lateral oriented transistor embodied in a semiconductor material in accordance with the disclosure.

### Detailed description

It is noted that in the description of the figures, same reference numerals refer to the same of similar components performing a same of essentially similar function.

A more detailed description is made with reference to particular examples, some of which are illustrated in the appended drawings, such that the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or" in reference to a list of two or more items, covers all the following interpretations of the word: any of the items in the list, all of the items in the list, and any combination of the items in the list.

These and other changes can be made to the technology considering the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein.

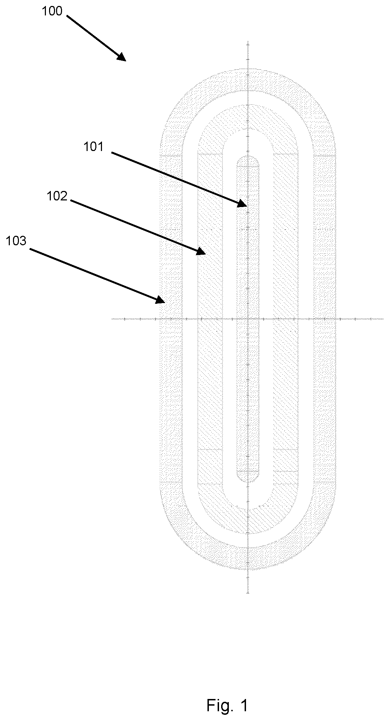

Fig. 1 depicts a transistor cell 100 in accordance with the disclosure. Herein is depicted a source/drain 101 which is surrounded by a gate 102, which in turn is surrounded by a drain/source 103. As mentioned before, the advantage of the drain/source 103 continuously wrapping around the plurality of gate structures is that it can improve the isolation between the source/drain 101 and the drain/source 103.

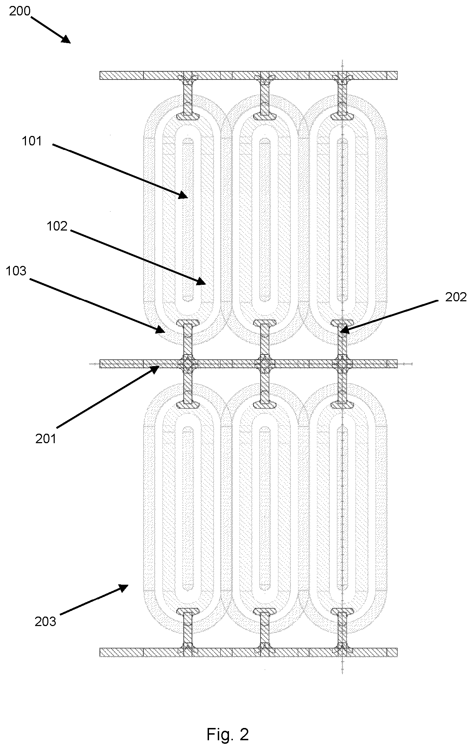

Fig. 2 depicts a lateral oriented transistor embodied in a semiconductor material in accordance with the disclosure. Herein is depicted a source/drain 101 which is surrounded by a gate 102, which in turn is surrounded by a drain/source 103. As mentioned before, the advantage of the drain/source 103 continuously wrapping around the plurality of gate structures is that it can improve the isolation between the source/drain 101 and the drain/source 103. In this figure, two groups 203 of cells 100 comprising these elements is provided. Further, in the figure a longitudinal gate interconnect 201 placed in between two groups 203 of transistor cells 100 is depicted. The gates 102 of the groups 203 of transistor cells 100, are connected to the gate interconnect 201 by a interconnect via 202. This gate interconnect lies in a different layer than the groups 203 of transistor cells 100, which may be a metallization layer.

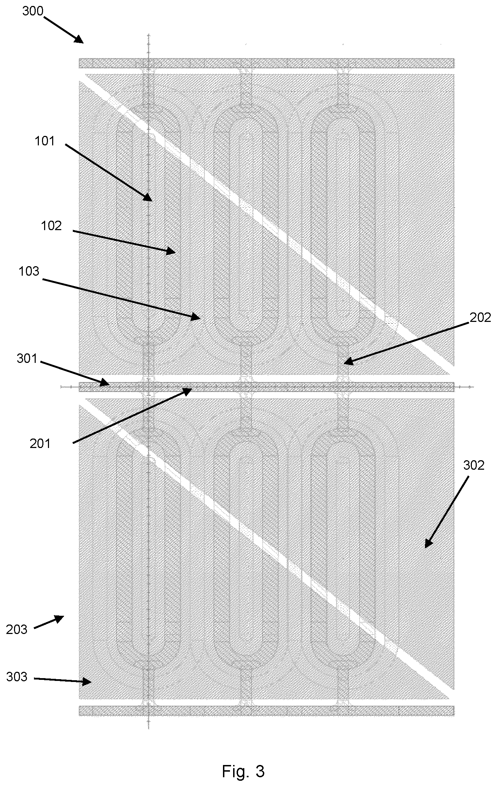

Fig. 3 depicts a lateral oriented transistor embodied in a semiconductor material in accordance with the disclosure. Herein is depicted a source/drain 101 which is surrounded by a gate 102, which in turn is surrounded by a drain/source 103. As mentioned before, the advantage of the drain/source 103 continuously wrapping around the plurality of gate structures is that it can improve the isolation between the source/drain 101 and the drain/source 103. In this figure, two groups 203 of cells 100 comprising these elements is provided. Further, in the figure a longitudinal gate interconnect 201 placed in between two groups 203 of transistor cells 100 is depicted. The gates 102 of the groups 203 of transistor cells 100, are connected to the gate interconnect 201 by a interconnect via 202. This gate interconnect lies in a different layer than the groups 203 of transistor cells 100, which may be a metallization layer.

The lateral oriented transistor further comprises a source and a drain plane 302 303, which is provided to improve the homogeneity of the current distribution over the package. The gate interconnect further is connected to a gate plane 301.

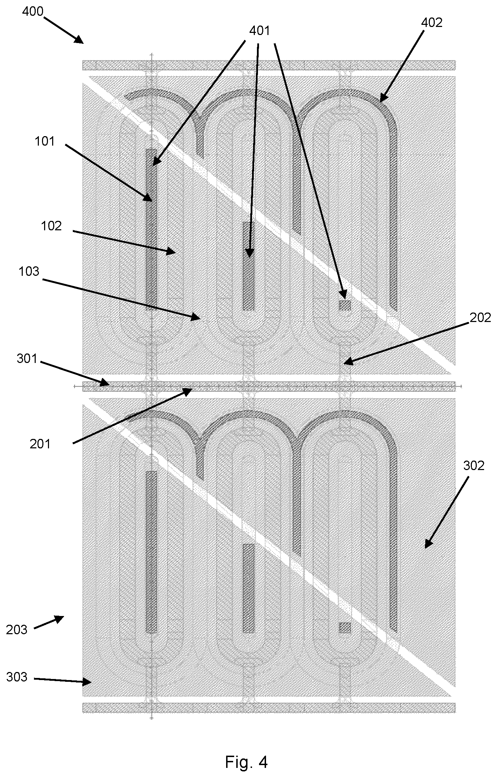

Fig. 4 depicts a lateral oriented transistor embodied in a semiconductor material in accordance with the disclosure. Herein is depicted a source/drain 101 which is surrounded by a gate 102, which in turn is surrounded by a drain/source 103. As mentioned before, the advantage of the drain/source 103 continuously wrapping around the plurality of gate structures is that it can improve the isolation between the source/drain 101 and the drain/source 103. In this figure, two groups 203 of cells 100 comprising these elements is provided. Further, in the figure a longitudinal gate interconnect 201 placed in between two groups 203 of transistor cells 100 is depicted. The gates 102 of the groups 203 of transistor cells 100, are connected to the gate interconnect 201 by a interconnect via 202. This gate interconnect lies in a different layer than the groups 203 of transistor cells 100, which may be a metallization layer.

The lateral oriented transistor further comprises a source and a drain plane 302 303, which is provided to improve the homogeneity of the current distribution over the package. The gate interconnect further is connected to a gate plane 301. The source and drain are connected to the triangular plane, separated diagonally, by a via. The source via 401 is connected to the source plane 302 and the source 101 and the drain via 402 is connected to the drain plane 303 and the drain 103.

As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms.

Accordingly, the actual scope of the technology encompasses not only the disclosed examples, but also all equivalent ways of practicing or implementing the technology under the claims

## Claims

1. A lateral oriented transistor embodied in a semiconductor material, comprising:
- a first group of directly adjacently placed transistor cells;
- a second group of directly adjacently placed transistor cells, wherein said second group is spaced apart from said first group thereby providing a spacing;
wherein each of said transistor cells comprises a drain, a source and a gate;
wherein said lateral oriented transistor further comprises a gate interconnect placed in said spacing between said first and second group, wherein said gate interconnect connects to said gates of said transistor cells.

2. A lateral oriented transistor in accordance with claim 2, wherein the lateral oriented transistor is a Gallium Nitride, GaN, High Electron Mobility Transistor, HEMT.

3. A lateral oriented transistor in accordance with any of the previous claims, wherein, seen from a top view of said laterally oriented transistor:
- one of the corresponding source and drain wraps around gate; and
- the gate wraps around the corresponding other of the source and the drain.

4. A lateral oriented transistor in accordance with claim 3, wherein the transistor cells of a same group are directly adjacent such that they share a part of said one of said source and drain.

5. A lateral oriented transistor in accordance with any of the previous claims, wherein said transistor comprises a source metallization plane and a drain metallization plane, wherein drains of said transistor cells are connected to said drain metallization plane using drain vias and sources of said transistor cells are connected to said source metallization plane using source vias.

6. A lateral oriented transistor in accordance with claim 5, wherein said source metallization plane and said drain metallization plane are oriented on a same layer.

7. A lateral oriented transistor in accordance with claim 6, wherein the source metallization plane and the drain metallization plane are separated diagonally relative to a longitudinal direction of said spacing such that at least one triangular source metallization plane and at least one triangular drain metallization plane are formed.

8. A lateral oriented transistor in accordance with claim 7, wherein said drains of said transistor cells are connected to said drain metallization plane using drain vias directly underneath said drain metallization plane, and wherein sources of said transistor cells are connected to said source metallization plane using source vias directly underneath said source metallization plane.

9. A lateral oriented transistor in accordance with claim 8, wherein said diagonal separation is formed within a same group of transistor cells.

10. A lateral oriented transistor in accordance with any of the previous claims, wherein the gate interconnect is positioned in a metallization layer.

11. A lateral oriented transistor in accordance with any of the claims 9 and 10, wherein said gate interconnect is positioned in a same metallization layer as said drain metallization plane and said source metallization plane.

12. A lateral oriented transistor in accordance with any of the previous claims, wherein the gate interconnect extends longitudinally between said two groups of transistor cells.

13. A lateral oriented transistor in accordance with any of the previous claims, wherein said transistor further comprises:
- a further gate interconnect, parallel to said gate interconnect, and placed at an opposite side of at least one of said first and second group of transistor cells.

14. A lateral oriented transistor in accordance with any of the previous claims, wherein each of said first and second group of transistor cells comprises twenty - eighty transistor cells.

15. A semiconductor package comprising a lateral oriented transistor in accordance with any of the previous claims.
